Europäisches Patentamt

European Patent Office

Office européen des brevets

(19)

(11) Publication number: **0 343 017**
**A2**

# (12) EUROPEAN PATENT APPLICATION

(21) Application number: **89305165.6**

(22) Date of filing: **22.05.89**

(51) Int. Cl.⁴: **H 01 J 37/32**

(30) Priority: **20.05.88 JP 123658/88**
**23.05.88 JP 125390/88**

(43) Date of publication of application:
**23.11.89 Bulletin 89/47**

(84) Designated Contracting States: **DE FR GB**

(71) Applicant: **NEC CORPORATION**
**33-1, Shiba 5-chome, Minato-ku**
**Tokyo 108 (JP)**

(72) Inventor: **Samukawa, Seiji**
**c/o NEC Corporation 33-1 Shiba 5-chome**
**Minato-ku Tokyo (JP)**

(74) Representative: **Abnett, Richard Charles et al**
**REDDIE & GROSE 16 Theobalds Road**
**London WC1X 8PL (GB)**

(54) **Reactive ion etching apparatus.**

(57) In order to correct plasma divergence in an electron cyclotron resonance etching apparatus, a magnetic throttle is provided. In one embodiment, the magnetic throttling is induced by a magnetic coil (40) disposed in a manner to surround a chamber (42) in which the etching is performed or disposed adjacent the specimen (44).

FIG. 3

**Description**

# REACTIVE ION ETCHING APPARATUS

This invention relates generally to a reactive ion etching apparatus and more specifically to such an apparatus in which electron cyclotron resonance is induced to produce a highly ionized plasma.

Fabrication of high density ICs (integrated circuits) requires strict dimensional control. To this end, dry or plasma-assisted etching techniques have been proposed. The conventional dry etching arrangements, however, have failed to simultaneously satisfy the following requirements: anisotropic etch, high etch rate, high selectivity and low substrate damage.

In order to overcome this difficulty, a reactive ion etching technology using electron cyclotron resonance (ECR) has been proposed in Japanese laid-open patent application (Tokkaisho) No. 60-120525.

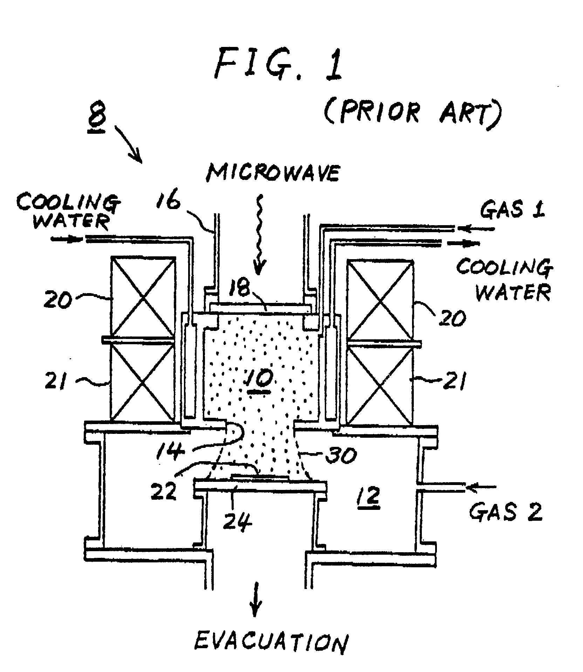

This Japanese laid-open patent application No. 60-120525 discloses an etching apparatus as shown in Fig. 1. The same apparatus as illustrated in Fig. 1 has also been disclosed in Proc. 1985 Symp. on VLSI Technol., (1985) VII-8, pp 84-85 by the inventors of the above-mentioned laid-open Japanese patent application.

Before describing in detail the present invention the known apparatus as shown in Fig. 1 will be described. The etching apparatus, depicted by reference numeral 8, includes a plasma chamber 10 and a reaction chamber (specimen chamber) 12. An opening 14 is provided between the two separate chambers 10, 12 and serves to introduce ion stream (plasma stream) from the plasma chamber 10 into the reaction chamber 12. As shown, a rectangular waveguide 16 is provided for guiding microwave (2.45 GHz) from a magnetron (not shown) into the plasma chamber 10 through a quartz window 18. The chamber 10 is surrounded by two magnetic ring coils 20, 21. A specimen substrate 22 is located on a substrate supporting table 24 within the chamber 12. With this arrangement, a highly ionized plasma is generated at low gas pressures of 0.01Pa within the chamber 10 under an ECR condition wherein the frequency of microwave (2.45 GHz) coincides with the electron cyclotron frequency determined by the magnetic flux density (875 Gauss). The magnetic flux density decreases gradually from the ECR region within the chamber 10 to the table 24, and an ion stream (plasma stream) is extracted from the plasma chamber 10 through the opening 14 along the magnetic gradient, viz., along the divergent magnetic field. According to the article in the aforesaid "Proc. 1985 Symp.", high ion current densities over 5mA/cm$^2$ were obtained by using the "divergent magnetic field".

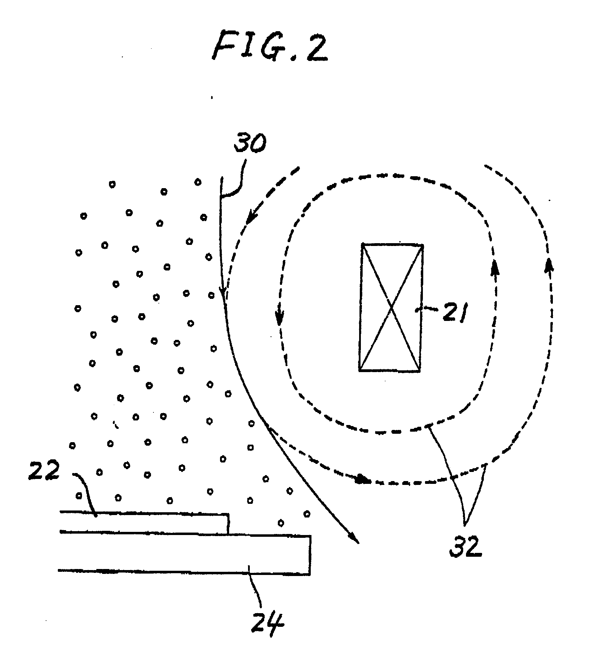

As mentioned above, the prior art shown in Fig. 1 extracts plasma stream from the chamber 10 utilizing the divergent magnetic field. The cross section of the plasma stream received through the opening 14 is schematically shown by reference numeral 30. This means that incidence angles of ions on the substrate 22 are different between the central and peripheral portions. This difference of incidence angles of ions causes damage to the substrate 22 and also adversely affects anisotropic etching with the result of so-called undercutting. Fig. 2 illustrates how the plasma streams received from the chamber 10 diverges due to magnetic fluxes 32 generated around the magnetic coil 21. Further description of Fig. 2 may be unnecessary to those skilled in the art.

## SUMMARY OF THE INVENTION

It is an object of this invention to provide a reactive ion etching apparatus in which bombardment of ions onto a specimen substrate is substantially normal to the surface of the substrate over the entire thereof.

Another object of this invention is to provide a reactive ion etching apparatus which is provided with a compensation magnetic coil for deflecting divergent magnetic field in order to bombard ions normally onto a specimen substrate.

Still another object of this invention is to provide a reactive ion etching apparatus in which ions transfer from a plasma chamber to a specimen chamber due to pressure difference between the two chambers and are then accelerated in a straight manner as to normally bombard a substrate.

One aspect of this invention takes the form of a reactive ion etching apparatus, comprising: a plasma chamber to which a reactive gas and a microwave are applied, said microwave having a predetermined frequency; first magnetic field generator which is provided around the outside of the plasma chamber and supplies the plasma chamber with a predetermined strength of magnetic field, a reactive gas plasma being generated within the plasma chamber by inducing electron cyclotron resonance; a reaction chamber which communicates with the plasma chamber through an opening and in which a specimen substrate is positioned on a substrate supporter disk, the reaction chamber receiving plasma streams from the plasma chamber under the influence of a magnetic field produced by the first magnetic field generator; and second magnetic field generator for modifying the magnetic field produced by the first magnetic field generator in a manner wherein the plasma stream is directed substantially normally to the surface of the specimen substrate.

Another aspect of this invention takes the form of a reactive ion etching apparatus, comprising: a plasma chamber to which a reactive gas is applied, the microwave generating a reactive gas plasma; a reaction chamber which communicates with the plasma chamber through an orifice and in which a specimen substrate is positioned on a substrate supporter disk, the reaction chamber receiving plasma streams from the plasma chamber under the influence of a pressure difference between the plasma chamber and the reaction chamber; and a magnetic field generator for controlling the plasma streams received by the reaction chamber in a manner wherein the plasma streams are directed substantially normally to the surface of the specimen substrate.

## BRIEF DESCRIPTION OF THE DRAWINGS

The features and advantages of the present invention will become more clearly appreciated from the following description taken in conjunction with the accompanying drawings in which like elements are denoted by like reference numerals and in which:

Fig. 1 is a cross-sectional view of a known reactive ion etching apparatus;

Fig. 2 is a diagram illustrating part of divergent magnetic field referred to in Fig. 1;

Fig. 3 is a cross-sectional view of the first embodiment of this invention;

Fig. 4 is a cross-sectional view of the second embodiment of this invention;

Fig. 5 is a diagram illustrating part of divergent magnetic field which is modified in accordance with this invention;

Fig. 6A is a diagram showing one result of experiments in connection with one embodiment of this invention;

Fig. 6B is a diagram for use in understanding the Fig. 6A diagram; and

Fig. 7 is a cross-sectional view of the third embodiment of this invention.

## DETAILED DESCRIPTION OF THE PREFERRED EMBODIMENT

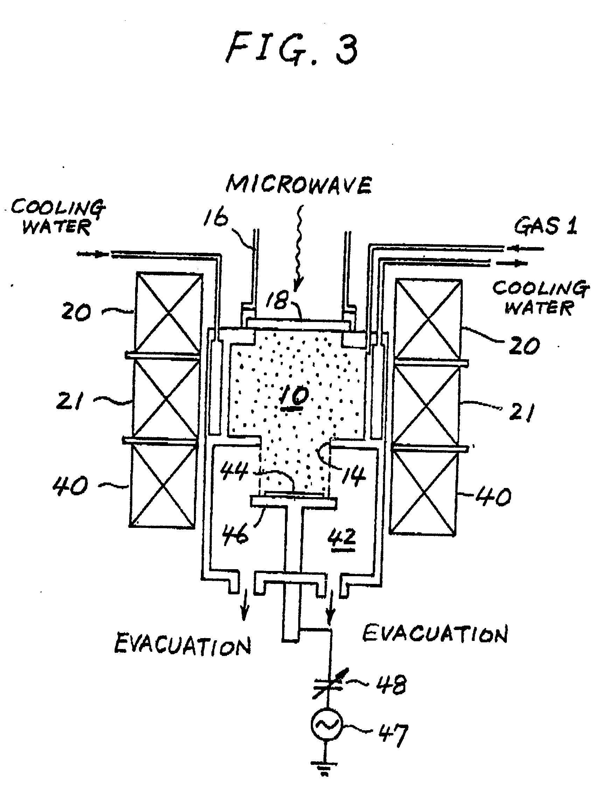

The first embodiment of this invention is schematically illustrated in Fig. 3. A primary difference between the arrangement of Fig. 3 and that of Fig. 1 is that the former arrangement further includes a compensation magnetic coil 40. As shown, the coil 40 is provided around the outside of a specimen chamber 42. The provision of the magnetic coil 40 is to deflect or modify the divergent magnetic field in order that ions extracted from the chamber 10 bombard perpendicularly a specimen substrate 44. The substrate 44 is mounted on a substrate supporting disk or table 46 to which an RF (radio frequency) bias power supply 47 is coupled via a variable condenser 48.

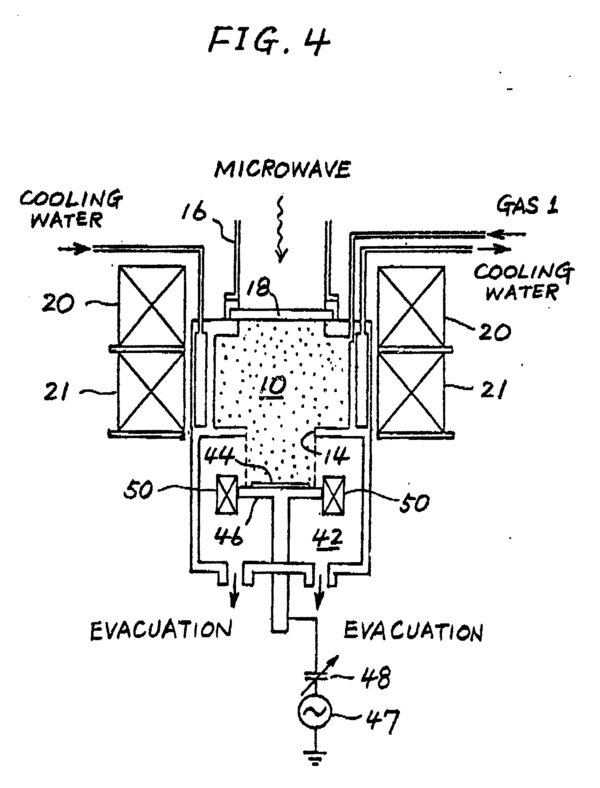

The second embodiment of this invention is shown in Fig. 4 whose arrangement is identical to the first embodiment except that a compensation magnetic coil 50 is positioned within the reaction chamber 42 and is arranged around the supporting disk 46. The purposes of providing the magnetic coils 40 and 50 are identical with each other.

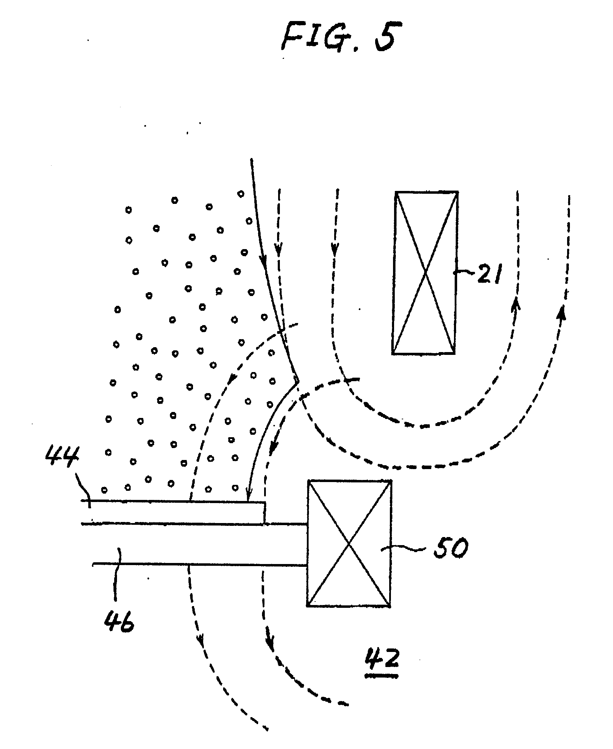

Fig. 5 illustrates a manner where the ions derived from the plasma chamber 10 are deflected within the reactive chamber 42 so as to perpendicularly impinge the surface of the substrate 44. As shown, the divergent magnetic field induced by the coil 21 is throttled to direct travelling ions towards the surface of the substrate 44. It should be noted that Fig. 5 is exaggeratedly drafted for a better understanding.

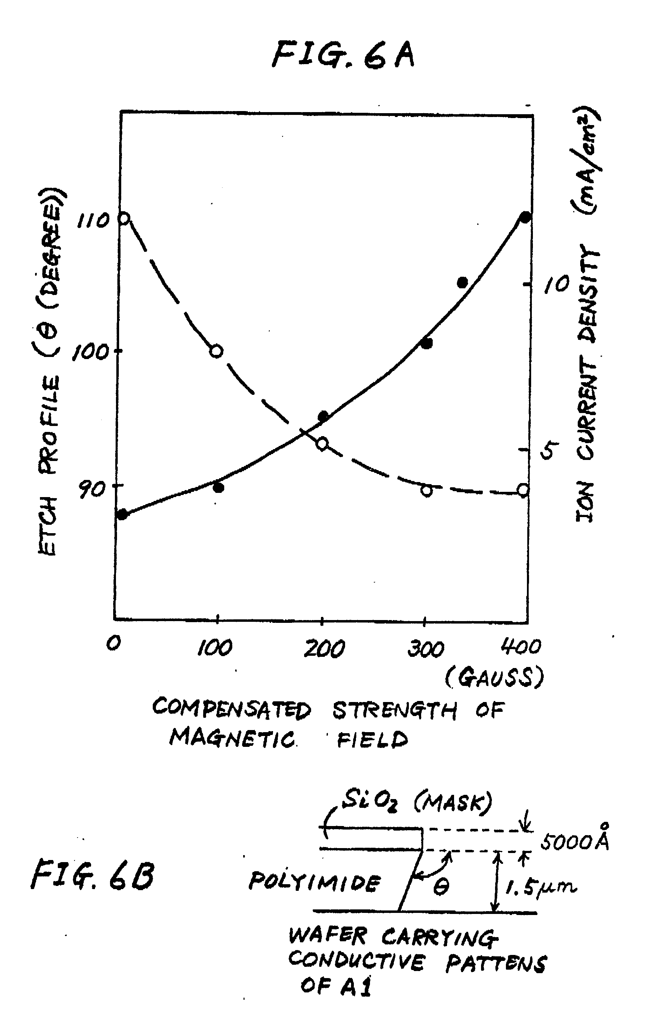

Reference is now returned to Fig. 3. According to experiments made by the inventor, the etching characteristics as a function of "compensated strength of magnetic field" shown in Fig. 6A was obtained under the following conditions:

(a) a polyimide film was formed up to $1.5\mu m$ on a semiconductor wafer on which aluminum conductive patterns were already provided;

(b) $SiO_2$ film of 5000Å for use as mask was selectively deposited on the polyimide film referred to in item (a) (see Fig. 6B);

(c) then, the wafer was placed on the supporter table 46, after which the chambers 10, 42 was evacuated to a pressure ranging from $1 \times 10^{-3}$ to $1 \times 10^{-4}$ Torr;

(d) microwave (2.45GHz, 600 watt) was introduced into the chamber 10, and the magnetic coils 20, 21 were adjusted such that magnetic field strength at a given point within the chamber 10 becomes 875 Gauss for inducing electron cyclotron resonance;

(e) $O_2$ gas was supplied to the chamber 10 as plasma gases in that polyimide film should be etched; and

(f) the wafer was zero-biased.

As understood from Fig. 6A, ion current density (measured above the wafer) increases as the magnetic field strength increases with the angle θ of an etched edge being maintained at about 90 degrees. It follows that according to this invention etch rate can considerably be improved as compared with the case where the compensation coil 40 is not energized. These advantages are also found in the second embodiment as shown in Fig. 2.

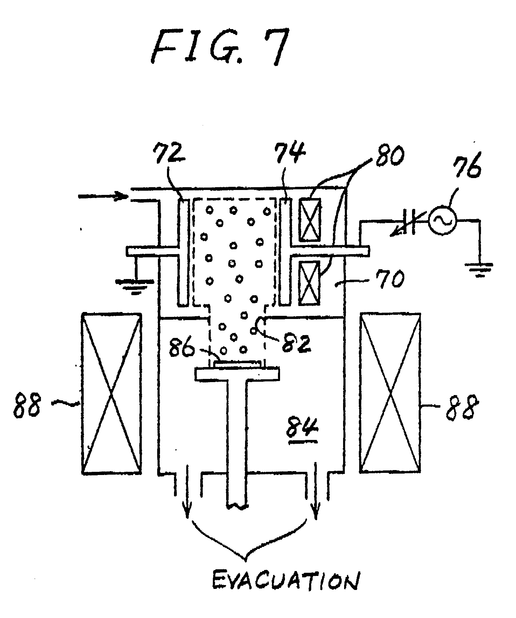

Fig. 7 schematically illustrates the third embodiment of this invention. A plasma chamber or discharge chamber 70 includes two parallel electric plates 72, 74 between which high frequency energy (13.56 MHz) is applied from an RF power supply 76. A magnetic coil or permanent magnet 80 generates magnetic field which is perpendicular to the high frequency electric field between the plates 72, 74. It is understood that a reactive gas plasma is generated due to so-called magnetron discharge. A plasma thus generated within the chamber 70 is transferred via an orifice 82 to a reaction chamber 84 utilizing a pressure difference between the chamber 70 and 84. Plasma streams received by the chamber 84 are perpendicularly directed to a specimen substrate 86 under the influence of magnetic field controlled by a ring-shaped magnetic coil 88. It is apparent therefore that this embodiment is free from the problems inherent in the conventional reactive ion etching apparatus as shown in Fig. 1.

The foregoing description shows only preferred embodiments of the present invention. Various modifications are apparent to those skilled in the art without departing from the scope of this invention which is only limited by the appended claims.

## Claims

1. A reactive ion etching apparatus, comprising:

a plasma chamber to which a reactive gas and a microwave are applied, said microwave having a predetermined frequency;

first magnetic field generator which is provided around the outside of said plasma chamber and supplies said plasma chamber with a predetermined strength of magnetic field, a reactive gas plasma being generated within said plasma chamber by inducing electron cyclotron resonance;

a reaction chamber which communicates with said plasma chamber through an opening and in which a specimen substrate is positioned on a substrate support disk, said reaction chamber receiving plasma streams from said plasma chamber under the influence of a magnetic field produced by said first magnetic field generator; and

second magnetic field generator for modifying said magnetic field produced by said first magnetic field generator in a manner wherein said plasma stream is directed substantially normally to the surface of said specimen substrate.

2. A reactive ion etching apparatus as claimed in claim 1, wherein said second magnetic field is provided around the outside of said reaction chamber.

3. A reactive ion etching apparatus as claimed in claim 1, wherein said second magnetic field is provided within said reaction chamber such as to surround said substrate supporter table.

4. A reactive ion etching apparatus, comprising:

a plasma chamber to which a reactive gas is applied, said microwave generating a reactive gas plasma;

a reaction chamber which communicates with said plasma chamber through an orifice and in which a specimen substrate is positioned on a substrate supporter disk, said reaction chamber receiving plasma streams from said plasma chamber under the influence of a pressure difference between said plasma chamber and said reaction chamber; and

a magnetic field generator for controlling the plasma streams received by said reaction chamber in a manner wherein said plasma streams are directed substantially normally to the surface of said specimen substrate.

# FIG. 1

(PRIOR ART)

<u>8</u>

MICROWAVE

COOLING WATER

GAS 1

COOLING WATER

16

18

20

20

21

21

<u>10</u>

14

30

22

24

<u>12</u>

GAS 2

EVACUATION

# FIG.2

# FIG. 3

# FIG. 4

# FIG. 5

# FIG. 6A

COMPENSATED STRENGTH OF
MAGNETIC FIELD

# FIG. 6B

WAFER CARRYING
CONDUCTIVE PATTERNS
OF A1

# FIG. 7

EVACUATION